# EUROPEAN PATENT APPLICATION

(11) **EP 0 653 905 A1**
(43) Date of publication of application: **17.05.1995**
(21) Application number: 94308374.1
(22) Date of filing: 14.11.1994
(51) Int. Cl.: H05K 3/40, H05K 3/36

(54) **Direct chip attach module**

(30) Priority: 16.11.1993 GB 9323646
(71) Applicant: International Business Machines Corporation, Armonk, N.Y. 10504 (US)
(72) Inventor: Downie, Alan Peter, Greenock, Scotland (GB); Gallagher, Peter, Greenock PA16 8RH, Scotland (GB); Garrity, John Joseph, Gourock, Strathclyde, Scotland (GB); Robertson, Brian Leslie, Gourock PA19 1UU, Scotland (GB)
(74) Representative: Williams, Julian David

(57) **Abstract**

A direct chip attach module (DCAM) 10 comprises one or more electronic components 30 bonded to a printed circuit on a substrate. The DCAM is bonded to an electronic circuit assembly by means of connection pads 50 formed on the edge of the DCAM substrate. This enables easy visual inspection of solder joints between the DCAM and the assembly.

DCAM substrates 70 are provided in panel form and vias 50 are drilled and plated at predetermined connection points. The DCAM is then excised from the panel and the cut vias provide connection pads 50 on the edge of the substrate.

## Description

The present invention relates to the assembly of electronic circuits. More specifically the present invention relates to the attachment of circuit components onto planar circuit boards.

A problem in the manufacture of integrated circuits and planar circuit boards is the attachment of chips and other circuit components to the substrate (or board) and the making of interconnections between components attached to a common substrate. A known method for attaching components is to solder the component pins into holes drilled at regular intervals through the substrate (or card). This is commonly known as pin in hole technology (PIH). An example of PIH technology is shown in Figure la. Problems with this technology are that it is not practical to attach components to both sides of the card and the components with associated pins take up a lot of space on the card.

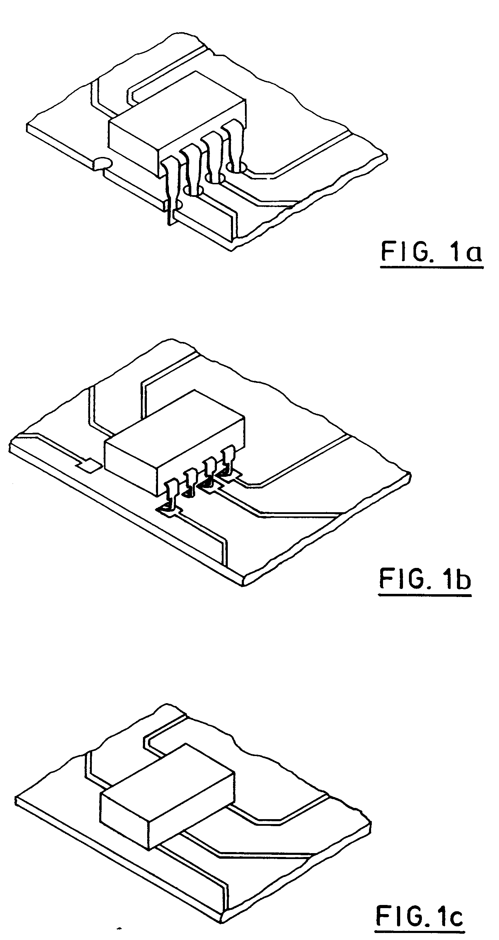

An alternative method of attaching components and chips is by utilising surface mount technology (SMT) in which components are attached to the surface of a printed circuit card. Holes are only drilled where necessary in order to make interconnections between wiring layers of the cards. An example of a component attached by SMT is shown in figure 1b. Advantages of this system are reduced drilling costs and more card space for wiring. Components can be easily attached to both sides of the card and can be mounted closer together. As the component lead-to-lead pitch is narrower in SMT than the pin-to-pin pitch in PIH, components can have more leads and therefore more functions. Furthermore many holes close together have a weakening effect on the mechanical strength of the substrate. Modern needs demand more dense circuit packages and with this comes more complex assembly processes.

Accordingly, another method developed for attaching chips to a substrate is direct chip attach (DCA). As with SMT holes are only drilled where necessary to make interconnections between wiring layers in the card. However, the chips have electrically conductive pads on their underside, rather than legs or pins, for connection. An example of a DCA chip is shown in Figure 1c. The connections between the chip and the substrate cannot actually be seen as they are underneath the chip. These chips are attached to a circuit board by C-4 soldering (controlled collapse chip connection) in which solder balls are formed or placed on the circuit connection pads. The leadless chip is then placed on top and the solder reflowed by known methods which include hot vapour reflow and infrared radiation.

Another method of direct chip attachment is that of DCAM (Direct Chip Attach Module) in which the silicon chip or chips are mounted onto a substrate using the technique of C-4 soldering. The substrate in turn has solderable pads on its underside which are used to solder the DCAM to a circuit board by the use of a printed solder paste and some form of heat application.

DCAM enables increased circuit density and allows reductions in the size of printed circuit cards. However, one of the problems experienced with the assembly of DCAM components onto planar boards is that once attached, there are no easy visual ways of inspecting the quality of a solder joint beneath a component and the joints are very difficult to get to with a heat source to reflow the joint during repair. Also, if a component is bonded too close to the surface of the substrate, flux and other contaminants could be entrapped resulting in unwanted solder balls and voids and the necessary removal and reattachment of the component.

Viewed from one aspect the present invention provides a method for manufacturing an electronic circuit module comprising the steps of: bonding one or more electronic components to a substrate carrying an printed circuit such that the component or components are in electrical contact with the printed circuit; forming vias through the substrate at predetermined connection points of the printed circuit; plating the vias with an electrically conductive material; and excising the printed circuit and attached components from the substrate so as to cut through the vias, thereby providing an electrically conductive connection pad on the edge of the substrate.

Viewed from another aspect the present invention provides an electronic circuit module comprising: a substrate carrying a printed circuit; one or more electronic components bonded to the substrate so as to be in electrical contact with the printed circuit; and at least one electrically conductive connection pad formed on an edge of the substrate.

This method of producing an electronic circuit module enables dense packaging of components onto a substrate with the added advantage that it provides for easy visual inspection of solder connections between the circuit module and an electronic circuit to which it is attached.

In order that the invention may be fully understood preferred embodiments thereof will now be described, by way of example only, with reference to the accompanying drawings in which:
Figure 1a shows an electronic component bonded to a substrate using prior art pin in hole technology;
Figure 1b shows an electronic component bonded to a substrate using prior art surface mount technology;
Figure 1c shows an electronic component bonded to a substrate using prior art direct chip attach technology;
Figure 2a shows a prior art direct chip attach module attached to a substrate;
Figure 2b shows the underside of the direct chip attach module of Figure 2a;
Figure 3 shows direct chip attach modules in panel form at component -manufacture;
Figure 4 shows the underside of a direct chip attach module after routing with the electrically conductive pads and copper plated vias exposed; and
Figure 5 shows a direct chip attach module bonded to a printed circuit board in accordance with the present invention.

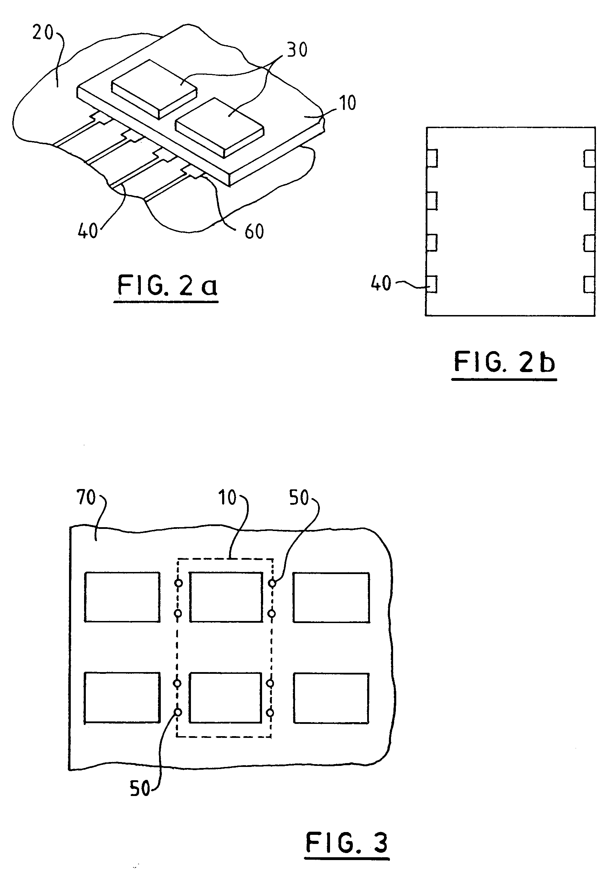

Figure 2a shows a prior art direct chip attach module 10 bonded to a substrate 20 by direct chip attachment. The module 10 includes a pair of chips 30 but may of course include more chips and/or other components depending on the function which the module is required to execute. Such module is generally a field replaceable unit i.e. one which is replaced rather than repaired when defective. The module is bonded to the circuit lines 40 of the substrate by solder located between the connection pads of the module and the connection pads 60 of the substrate circuit. The connection pads of the module cannot be seen under the module shown in Figure 2a but are shown as 45 in Figure 2b.

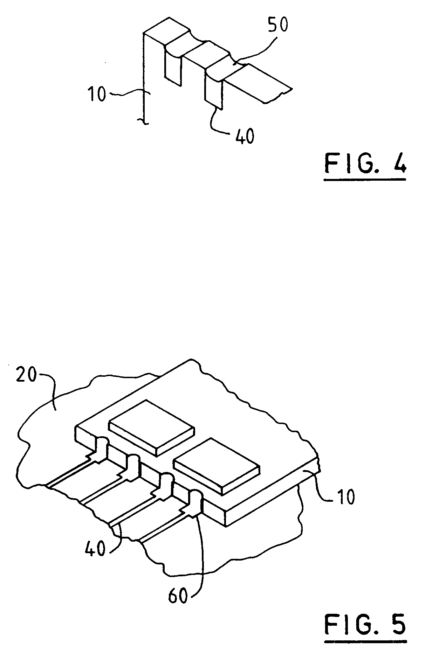

The direct chip attach modules (DCAMs) shown in Figure 2 are conventionally manufactured in panel form i.e. manufactured on a wafer and then excised. The wafer is preferably FR4 substrate. In accordance with the present invention the modules are manufactured in panel form and via 50 is formed at the edge of each connection pad as is shown in Figure 3. The via is plated with an electrically conductive material. In accordance with a preferred embodiment of the invention, the via is plated with copper. When the DCAM is routed from the parent panel 70 the router cuts through each via, cutting the via in two as is shown by the dotted line in Figure 3 to leave a DCAM with typical dimensions of about 10mm by 20mm. This results in the formation of an electrically conductive pad which extends up the side of the DCAM component as shown in Figure 4.

The DCAM may then be bonded to connection pads of a printed circuit card by a conventional bonding method but preferably by means of C-4 solder balls. Figure 5 shows a DCAM bonded to a substrate. The solder joint fillet is visible at connection pad 60 for inspection purposes and is much more accessible for repair tools. This method of bonding components maintains the advantage of being able to densely pack components onto a substrate with the added advantage of being able to see the connections.

## Claims

1. A method for manufacturing an electronic circuit module comprising the steps of:
bonding one or more electronic components to a substrate carrying an printed circuit such that the component or components are in electrical contact with the printed circuit;
forming vias through the substrate at predetermined connection points of the printed circuit;
plating the vias with an electrically conductive material; and
excising the printed circuit and attached components from the substrate so as to cut through the vias, thereby providing an electrically conductive connection pad on the edge of the substrate.

2. A method for manufacturing an electronic circuit assembly comprising the step of:
bonding one or more electronic circuit modules to the substrate such that the module or modules are in electrical contact with the printed circuit, electrical contact between the printed circuit and the module or modules being provided through an electrically conductive connection pad on an edge of a module.

3. An electronic circuit module comprising:
a substrate carrying a printed circuit;
one or more electronic components bonded to the substrate so as to be in electrical contact with the printed circuit; and
at least one electrically conductive connection pad formed on an edge of the substrate.

4. An electronic circuit assembly comprising:
a first substrate carrying a first printed circuit;
one or more electronic components bonded to the first substrate so as to be in electrical contact with the first printed circuit;
one or more electronic circuit modules bonded to the first substrate so as to be in electrical contact with the first printed circuit, each electronic circuit module comprising:
a second substrate carrying a second printed circuit;
one or more electronic components bonded to the second substrate so as to be in electrical contact with the second printed circuit; and
at least one electrically conductive connection pad formed on an edge of the second substrate, electrical contact between the first and second printed circuits provided through the electrically conductive connection pad on an edge of the second substrate.
